**Europäisches Patentamt**

**European Patent Office**

**Office européen des brevets**

(19)

(11) Numéro de publication : **0 353 110 B1**

(12)

# FASCICULE DE BREVET EUROPEEN

(45) Date de publication du fascicule du brevet :
**12.08.92 Bulletin 92/33**

(51) Int. Cl.$^5$ : **H05K 5/02**

(21) Numéro de dépôt : **89401686.4**

(22) Date de dépôt : **15.06.89**

(54) **Dispositif formant ouie d'aération pour boîtier de protection électrique ou électronique.**

(30) Priorité : **25.07.88 FR 8809996**

(43) Date de publication de la demande :
**31.01.90 Bulletin 90/05**

(45) Mention de la délivrance du brevet :
**12.08.92 Bulletin 92/33**

(84) Etats contractants désignés :
**AT BE CH DE ES GB GR IT LI LU NL SE**

(56) Documents cités :
**EP-A- 0 198 184**
**DE-U- 1 883 066**
**FR-A- 2 500 713**

(73) Titulaire : **LUDWIG SCHMITT GMBH Société
dite :
Zum Gerlen
W-6601 Saarbrücken-Ensheim (DE)**

(72) Inventeur : **Schwartz, Roman, Mr.
Heimeltstrasse 18
W-6601 Ensheim-Saarbrücken (DE)**
Inventeur : **Schmitt, Horst, Mr.
3, rue de la Gare
F-67260 Wolfskirchen (FR)**

(74) Mandataire : **Lerner, François et al
LERNER & BRULLE S.C.P. 5, rue Jules
Lefèbvre
F-75009 Paris (FR)**

**Description**

L'invention a pour objet un boîtier de protection électrique ou électronique, équipé d'une ouie d'aération.

Les boîtiers de protection électrique ou électronique généralement utilisés ont pour objet essentiel de soustraire les appareils qu'ils contiennent aux poussières extérieures ainsi qu'aux projections d'eau, pouvant provenir par exemple des intempéries ou d'un lavage intempestif d'une zone avoisinant le boîtier de protection.

Un tel dispositif est par exemple connu du document DE-U-18 83066 qui prévoit l'usage, pour coiffer le toit d'un boîtier pouvant recevoir les eaux de pluie, d'un chapeau en forme de champignon, qui recouvre des orifices de ventilation formés dans la paroi supérieure du boîtier, en ménageant entre le toit et le chapeau un étroit passage sinueux de ventilation, dont le dimensionnement est déterminé par une entretoise en forme de volant annulaire avec bras reliant un moyeu central et laissant passer l'air.

La solution généralement envisagée est de constituer un boîtier étanche. Mais lorsqu'on procède de cette façon, sous l'effet des variations de température ambiante, il se produit à l'intérieur du boîtier des condensations qui peuvent détériorer les appareillages contenus dans le boîtier, voire provoquer des courts-circuits. Pour éviter de telles condensations, il est donc nécessaire de prévoir un dispositif d'aération du boîtier permettant une certaine communication avec le milieu extérieur et qui devra assurer cependant la protection du volume intérieur du boîtier contre les projections d'eau.

Le boîtier équipé d'une ouie d'aération conforme à l'invention comporte

– un corps cylindrique comprenant :

. une partie annulaire qui s'adapte dans un orifice formé dans une paroi du corps du boîtier,

. en prolongement de cette partie annulaire une joue formant flasque de plus grande dimension périphérique que celle dudit orifice venant s'appliquer en position de montage sensiblement contre la paroi extérieure du boîtier, ledit flasque comportant des doigts faisant saillie en étoile vers l'extérieur, et étant formé successivement, quand on s'éloigne de la paroi du boîtier en se déplaçant parallèlement à l'axe du corps cylindrique, avec une bague à section sensiblement trapézoïdale dont le diamètre va en diminuant, et une partie comportant les doigts en étoile précités et dont la surface périphérique est plus grande que celle de la bague qui la jouxte,

. en prolongement dudit flasque au moins une paroi formée en tronc de cône allant en s'évasant quand on s'éloigne de la paroi du boîtier en se déplaçant parallèlement à l'axe du corps cylindrique,

– un bouchon ou chapeau venant se verrouiller sur l'extrémité desdits doigts en étoile en enveloppant et recouvrant avec un certain jeu la paroi précitée formée en tronc de cône.

Avec un tel dispositif, on assure une aération du boîtier en créant une communication contrôlée entre le volume intérieur du boîtier et le milieu extérieur, évitant les problèmes de condensation, et simultanément on protège efficacement le volume intérieur du boîtier contre toute projection d'eau, et cela au moyen d'un dispositif de conception simple et d'application particulièrement aisée.

L'invention et sa mise en oeuvre apparaîtront plus clairement à l'aide de la description qui va suivre faite en référence aux dessins annexés dans lesquels :

– la figure 1 est une vue générale en coupe axiale d'un dispositif conforme à l'invention en position de montage sur la paroi d'un boîtier,

– la figure 2 montre en coupe axiale le même dispositif en position éclatée,

– la figure 3 montre schématiquement en perspective la partie formant corps cylindrique du dispositif,

– la figure 4 montre vue de face selon la flèche IV de la figure 2, la section que présente la face extérieure du corps cylindrique illustré à la figure 3,

– la figure 5 est une vue de détail faite au niveau du cercle entouré V de la figure 2 relativement à une variante avec segment d'étanchéité intégré,

– la figure 6 est une vue semblable à celle de la figure 5 relative à une autre variante encore.

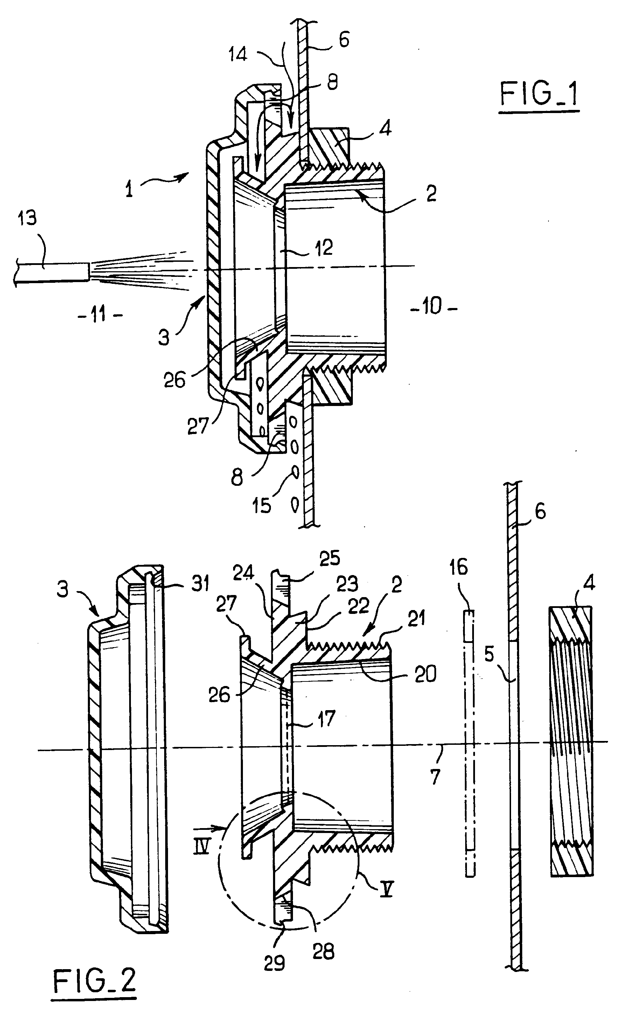

On décrira maintenant l'invention en se référant tout d'abord plus particulièrement aux figures 1 et 2.

Le dispositif formant ouie d'aération repéré dans son ensemble 1 comprend essentiellement, comme il apparaît plus clairement à la figure 2, un corps cylindrique 2, un bouchon ou chapeau 3 et un écrou 4 permettant son montage dans l'orifice 5 d'une paroi 6 de boîtier (lequel boîtier n'a pas été représenté dans son ensemble).

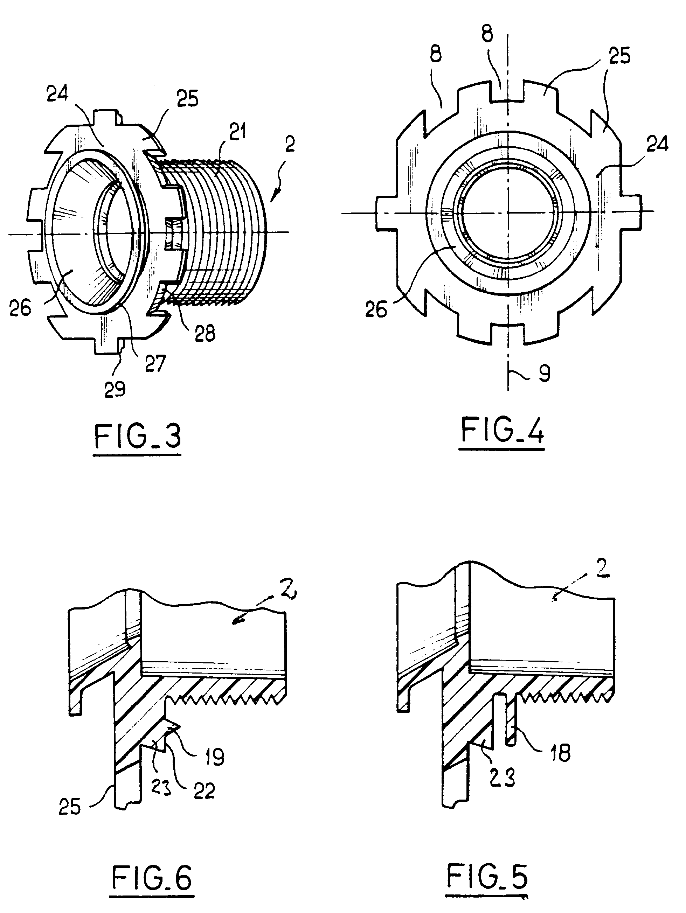

Le corps cylindrique 2, avantageusement constitué en polyamide moulé en une seule pièce comprend une partie annulaire 20 qui s'adapte dans l'orifice 5 de la paroi 6 et qui comporte vers son extrémité dirigée vers l'intérieur du volume du boîtier un filetage 21 sur lequel se visse l'écrou 4. En prolongement de la partie annulaire 20 on rencontre une joue 22 formant flasque, de plus grande dimension périphérique de celle de l'orifice 5 et qui vient s'appliquer en position de montage sensiblement contre la paroi extérieure du boîtier. Dans l'exemple illustré cette partie est formée, successivement quand on s'éloigne de la paroi du boîtier en se déplaçant parallèlement à l'axe 7 du corps cylindrique 20 d'une bague 23 à section sensiblement trapézoïdale dont le diamètre va en diminuant dans cette direction de déplacement, puis d'une partie 24, plus particulièrement visible à la figure 4, comportant des doigts 25 en étoile et dont la surface périphérique est plus grande que celle de la bague 23 qui la jouxte. En prolongement de la partie formant flasque 22 on rencontre ensuite, toujours en s'éloignant de la paroi du boîtier en se déplaçant parallèlement à l'axe 7 du corps cylindrique, une paroi 26 formée en tronc de cone allant en s'évasant dans cette direction et se terminant à son extrémité libre par un rebord 27 faisant saillie vers l'extérieur.

Dans le mode de réalisation illustré, le corps cylindrique 20 est de section générale sensiblement circulaire adapté à un orifice de section circulaire correspondante. Mais il est bien entendu que la section du corps cylindrique n'est pas limitée à une section circulaire et sera simplement de façon générale de section correspondante à celle de l'orifice formé dans la paroi du boîtier, par exemple rectangulaire hexagonale, ovale ou autre.

Entre les doigts 25 en étoile sont formées des ouvertures 8, plus particulièrement visibles à la figure 4. On notera que la direction générale des doigts 25 est parallèle à une plan repéré 9 à la figure 4 correspondant à la direction d'ouverture du moule de fabrication et permettant le démoulage de la pièce. On notera enfin que la partie 24 comportant les doigts 25 en étoile présente entre ces doigts une section 28 allant en s'élargissant lorsqu'on se déplace toujours dans la direction d'éloignement de la paroi du boîtier 6 le long de l'axe 7. Enfin on notera les dimensions des surfaces périphériques relatives respectives, moyenne pour la bague 23 à section trapézoïdale, grande pour la partie 24 sous-tendant les doigts 25 en étoile, et petite pour la partie formée en tronc de cone 26.

Aux figures 1 et 2 on aperçoit précisément la forme du capot ou chapeau 3 qui vient se fixer élastiquement par son rebord 31 convenablement conformée avec un retour venant se verrouiller sur l'extrémité conformé en crochet ou dent 29 des doigts en étoile 25.

Le fonctionnement du dispositif se déduit clairement de la construction décrite.

En se référant à la figure 1, on comprend que le volume intérieur du boîtier, repéré généralement 10, est en communication avec le milieu ambiant 11 par l'intermédiaire de l'orifice 12 central du corps cylindrique 2 et des passages en chicane formés entre le corps cylindrique 2 et le bouchon 3 et en particulier les passages 8 ménagés entre les doigts en étoile 25 du corps 2.

Si on dirige un jet d'eau comme schématisé en 13 en direction de l'ouie d'aération 1, le jet se brise sur le bouchon. Les projections d'eau pouvant retomber comme indiqué par les flèches 14 vont être canalisées et évacuées à l'extérieur de la paroi 6 comme schématisé par les gouttes 15. Ceci se produit à divers niveaux.

Tout d'abord la partie formant bague trapézoïdale 23 canalise l'eau à la manière d'une gouttière en évitant au maximum les remontées d'eau et leur passage à travers les ouvertures 8 prévues entre les doigts 25, du fait notamment que la bague 23 a une diamètre inférieur à celui de la paroi 24 qui la jouxte et qui soutend les doigts en étoile 25. Les éventuelles remontées d'eau à travers les passages 8 et qui sont contrariées par la section allant en croissant 28 de la base de ces ouvertures retomberont sur le cone 26 qui avec son rebord 27 canalisera efficacement les dernières retombées d'eau vers l'extérieur en étant éliminées par les passages 8 formés entre les dents 25 situées en position la plus basse.

On notera que du fait de la configuration particulière du dispositif, celui-ci fonctionne quelle que soit l'orientation au montage, ce qui constitue un grand avantage au niveau de l'utilisateur. Et par la mise de la communication de l'intérieur du boîtier avec l'extérieur, on évite simultanément les problèmes de condensation.

Bien des variantes et modifications peuvent être apportées au mode de réalisation illustré et décrit. En particulier, lorsque l'ouie d'aération est destinée à être montée sur un boîtier métallique, il peut être avantageux de prévoir un joint supplémentaire d'étanchéité tel que schématisé en 16 figure 2 qui sera interposé entre le flasque 22 et la paroi 6 du boîtier. De la même façon on peut avantageusement prévoir une grille 17 anti-insectes au niveau de l'orifice central du corps 2 qui peut être rapportée ou venir de matière de moulage avec le corps.

Dans la variante de réalisation de détail illustrée, à la figure 5 on fera venir le joint d'étanchéité 16 de la figure 2 directement de matière avec le corps cylindrique 2 en prévoyant à cet effet une fine collerette 18 comme illustré à cette figure 5.

En variante encore, comme illustré à la figure 6, la bague d'étanchéité peut être remplacée par un simple segment 19 formé sur la face 22 de la bague 23.

## Revendications

1. Boîtier de protection électrique ou électronique, équipé d'une ouie d'aération (1) et comportant:
   – un corps cylindrique (2) comprenant :
      . une partie annulaire (20) qui s'adapte dans un orifice (5) formé dans une paroi (6) du corps du boîtier,
      . en prolongement de cette partie annulaire (20) une joue (22) formant flasque de plus grande dimension périphérique que celle dudit orifice (5) venant s'appliquer en position de montage sensiblement contre la paroi extérieure du boîtier, ledit flasque comportant des doigts (25) faisant saillie en étoile vers l'extérieur, et étant formé successivement, quand on s'éloigne de la paroi du boîtier en se déplaçant parallèlement à l'axe (7) du corps cylindrique, avec une bague (23) à section sensiblement trapézoïdale dont le diamètre va en diminuant, et une partie (24) comportant les doigts (25) en étoile précités et dont la surface périphérique est plus grande que celle de la bague (23) qui la jouxte,

. en prolongement dudit flasque au moins une paroi (26) formée en tronc de cône allant en s'évasant quand on s'éloigne de la paroi (6) du boîtier en se déplaçant parallèlement à l'axe (7) du corps cylindrique,

– un bouchon ou chapeau (3) venant se verrouiller sur l'extrémité desdits doigts (25) en étoile en enveloppant et recouvrant avec un certain jeu la paroi précitée formée en tronc de cône (26).

2. Boîtier selon la revendication 1 caractérisé en ce que la partie comportant les doigts (25) en étoile présente entre ces doigts une section (28) allant en s'élargissant quand on s'éloigne de la paroi du boîtier en se déplaçant sensiblement parallèlement à l'axe (7) du corps cylindrique.

3. Boîtier selon la revendication 1 ou 2 caractérisé en ce que les parties précitées que l'on rencontre successivement quand on s'éloigne de la paroi du boîtier en se déplaçant parallèlement à l'axe (7) du corps cylindrique ont des surfaces relatives respectives : moyenne pour ladite bague (23) à section trapézoïdale, grande pour ladite partie (24) sous-tendant les doigts (25) en étoile, et petite pour la partie formée en tronc de cône (26).

4. Boîtier selon l'une des revendications précédentes caractérisé en ce que la paroi formée en tronc de cône (26) se termine à son extrémité libre par un rebord (27) faisant saillie vers l'extérieur.

5. Boîtier selon l'une des revendications précédentes caractérisé en ce que le corps cylindrique (2) précité est de section généralement sensiblement circulaire.

6. Boîtier selon l'une des revendications précédentes caractérisé en ce que les doigts (25) en étoile sont dirigés selon une direction de plan (9) correspondant à la direction d'ouverture du moule de fabrication.

7. Boîtier selon l'une des revendications précédentes caractérisé en ce que le corps cylindrique (2) comporte, venant de matière et faisant saillie axialement par rapport à la paroi de flasque (22) qui vient contre la paroi (6) du boîtier, un segment (19) ou une bague (18) d'étanchéité.

8. Boîtier selon l'une des revendications précédentes caractérisé en ce que le corps cylindrique est fileté au niveau de sa partie (21) qui s'adapte dans l'orifice (5) du boîtier pour l'adaptation d'un écrou (4) de fixation du dispositif.

9. Boîtier selon l'une des revendications précédentes caractérisé en ce qu'il comprend au niveau de l'orifice de la partie annulaire une grille (17) de protection contre les insectes.

**Patentansprüche**

1. Elektrisches oder elektronisches Schutzgehäuse, welches mit einem Entlüftungsloch (1) versehen ist und aufweist:

– einen zylindrischen Körper (2) mit:

. einem ringförmigen Teil (20), das in einer Öffnung (5) angepaßt ist, die in einer Wand (6) des Körpers des Gehäuses gebildet ist,

. in Verlängerung dieses ringförmigen Teils (20) einem Seitenteil (22), welches einen Flansch mit größerer Umfangsabmessung bildet als der der Öffnung (5), und der sich in Montageposition im wesentlichen gegen die Außenwand des Gehäuses ansetzt, wobei der Flansch Zapfen (25) aufweist, die in Sternform nach außen vorspringen, und der aufeinanderfolgend, wenn man sich von der Wand des Gehäuses entfernt, indem man sich parallel zur Achse (7) des zylindrischen Körpers versetzt, mit einem Ring (23) mit im wesentlichen trapezförmigem Querschnitt gebildet ist, dessen Durchmesser kleiner wird, und einem Teil (24) gebildet ist, welches Zapfen (25) in Sternform aufweist und dessen Umfangsoberfläche größer ist als die des benachbarten Ringes (23),

. in Verlängerung des Flansches mindestens einer Wand (26), die als Kegelstumpf gebildet ist und sich erweitert, wenn man sich von der Wand (6) des Gehäuses entfernt, indem man sich parallel zur Achse (7) des zylindrischen Körpers versetzt,

– einen Stopfen oder eine Haube (3) aufweist, die sich auf dem Ende der Zapfen (25) in Sternform verriegelt, indem sie mit einem gewissen Spiel die genannte Wand, die als Kegelstumpf (26) gebildet ist, umhüllt und bedeckt.

2. Gehäuse nach Anspruch 1, dadurch gekennzeichnet, daß das Teil, welches die Zapfen (25) in Sternform aufweist, zwischen diesen Zapfen einen Abschnitt (28) hat, der sich vergrößert, wenn man sich von der Wand des Gehäuses entfernt, indem man sich im wesentlichen parallel zur Achse (7) des zylindrischen Körpers versetzt.

3. Gehäuse nach Anspruch 1 oder 2, dadurch gekennzeichnet, daß die Teile, die man nach und nach antrifft, wenn man sich von der Wand des Gehäuses entfernt, indem man sich parallel zur Achse (7) des zylindrischen Körpers versetzt, jeweilige relative Oberflächen haben: eine mittlere für den Ring (23) mit trapezförmigem Querschnitt, eine große für das Teil (24), welches die Zapfen (25) in Sternform unterspannt, und eine kleine für das Teil, welches als Kegelstumpfform (26) geformt ist.

4. Gehäuse nach einem der vorhergehenden Ansprüche, dadurch gekennzeichnet, daß die kegelstumpfförmige Wand (26) an ihrem freien Ende in einer Leiste (27) endet, die nach außen vorsteht.

5. Gehäuse nach einem der vorhergehenden Ansprüche, dadurch gekennzeichnet, daß der zylindrische Körper (2) im allgemeinen im wesentlichen Kreisquerschnitt hat.

6. Gehäuse nach einem der vorhergehenden Ansprüche, dadurch gekennzeichnet, daß die Zapfen (25) in Sternform gemäß einer Richtung der Ebene (9) gerichtet sich, welche der Richtung der Öffnung der Herstellungsform entspricht.

7. Gehäuse nach einem der vorhergehenden Ansprüche, dadurch gekennzeichnet, daß der zylindrische Körper (2) ein Segment (19) oder einen Dichtigkeitsring (18) aufweist, welcher aus der Masse kommt und axial bezüglich der Wand des Flansches (22) vorspringt, der gegen die Wand (6) des Gehäuses anliegt.

8. Gehäuse nach einem der vorhergehenden Ansprüche, dadurch gekennzeichnet, daß der zylindrische Körper an seinem Teil (21) mit Gewinde versehen ist, welches sich in die Öffnung (5) des Gehäuses einpaßt für das Einpassen einer Befestigungsmutter (4) der Vorrichtung.

9. Gehäuse nach einem der vorhergehenden Ansprüche, dadurch gekennzeichnet, daß es an der Öffnung des ringförmigen Teils ein Gitter (17) zum Schutz gegen Insekten aufweist.


**Claims**

1. Electrical or electronic protection box provided with a ventilation louvre (1) and comprising:
   – a cylindrical body (2) comprising:
      . an annular section (20) which fits into an aperture (5) formed in a wall (6) of the box body;
      . in an extension of this annular section (20) a cheek (22) forming an end plate with a larger peripheral dimension than that of the said aperture (5) which is applied in the assembled position substantially against the outer wall of the box, the said end plate comprising fingers (25) which project externally in the manner of a star, and being formed successively, in the direction moving away from the box wall parallel to the axis (7) of the cylindrical body, with a collar (23) which has a substantially trapezoidal cross-section and of which the diameter decreases, and a section (24) comprising the aforementioned fingers (25) arranged in the manner of a star and of which the peripheral surface area is larger than that of the collar (23) which adjoins the latter;
      . in an extension of the said end plate at least one frustoconical wall (26) which widens in the direction moving away from the box wall (6) parallel to the axis (7) of the cylindrical body;
   – a plug or cap (3) locking onto the end of the said fingers (25) arranged in the manner of a star, enveloping and covering the aforementioned frustoconical wall (26) with a given degree of play.

2. Box according to Claim 1, characterised in that the section comprising the fingers (25) arranged in the manner of a star comprises between these fingers a section (28) which enlarges in the direction moving away from the box wall substantially parallel to the axis (7) of the cylindrical body.

3. Box according to Claim 1 or 2, characterised in that the aforementioned sections which are encountered successively in the direction moving away from the box wall parallel to the axis (7) of the cylindrical body have the following respective relative surfaces; a medium-sized surface for the said collar (23) having a trapezoidal cross-section, a large surface for the said section (24) supporting the fingers (25) arranged in the manner of a star and a small surface for the frustoconical section (26).

4. Box according to any one of the preceding claims, characterised in that the frustoconical wall (26) terminates at its free end in an edge (27) projecting towards the exterior.

5. Box according to any one of the preceding claims, characterised in that the aforementioned cylindrical body (2) has a generally substantially circular cross-section.

6. Box according to any one of the preceding claims, characterised in that the fingers (25) arranged in the manner of a star are directed in a plane direction (9) corresponding to the opening direction of the production mould.

7. Box according to any one of the preceding claims, characterised in that the cylindrical body (2) comprises a sealing ring (18) or segment (19) consisting of a single part and projecting axially relative to the wall of the end plate (22) which abuts against the wall (6) of the box.

8. Box according to any one of the preceding claims, characterised in that the cylindrical body is threaded at its section (21) which fits into the aperture (5) of the box in order to fit a nut (4) for securing the device.

9. Box according to any one of the preceding claims, characterised in that at the aperture of the annular section it comprises a grid (17) for protection against insects.

FIG_1

14

6

8

4

1

13

2

12

—11—

—10—

3

26

27

8

15

FIG_2

3

31

24

25

27

23

22

2

16

26

21

6

20

4

17

5

7

IV

V

29

28

FIG_3

FIG_4

FIG.6

FIG_5